# EUROPEAN PATENT APPLICATION

(11) **EP 2 682 264 A1**
(43) Date of publication of application: **08.01.2014**
(21) Application number: 12752249.8
(22) Date of filing: 15.02.2012
(51) Int. Cl.: B32B 15/09, C08J 7/00

(54) **LIQUID CRYSTAL POLYMER FILM BASED COPPER-CLAD LAMINATE, AND METHOD FOR PRODUCING SAME**

(30) Priority: 01.03.2011 JP 2011043462
(71) Applicant: JX Nippon Mining & Metals Corp., Chiyoda-ku Tokyo 100-8164 (JP)
(72) Inventor: SAKAGUCHI Kazuhiko, Hitachi-city Ibaraki 317-0056 (JP); INAZUMI Hajime, Hitachi-city Ibaraki 317-0056 (JP); YACHI Hisakazu, Hitachi-city Ibaraki 317-0056 (JP)
(74) Representative: Hoarton, Lloyd Douglas Charles
(86) International application number: PCT/JP2012/053454
(87) International publication number: WO 2012/117850

(57) **Abstract**

Provided is a liquid crystal polymer film based copper-clad laminate characterized in that a surface of one side or each of both sides of a liquid crystal polymer film has a nitrogen atom content of 10 at% or more, and a metal conductor layer formed by dry plating and/or wet painting is provided on the surface of the liquid crystal polymer film having the nitrogen atom content of 10 at% or more. The liquid crystal polymer film based copper-clad laminate is characterized by having arithmetic average roughness Ra of 0.15 µm or less and a root-mean-square roughness Rq of 0.20 µm or less as surface roughness of the liquid crystal polymer film. Also provided is a method for producing a liquid crystal polymer film based copper-clad laminate characterized by performing plasma processing on the surface of the liquid crystal polymer film under a nitrogen atmosphere at a gas pressure of 2.6 to 15 Pa, followed by forming the metal conductor layer by dry plating and/or wet plating.

## Description

### Technical Field

The present invention relates to a liquid crystal polymer film based copper-clad laminate having excellent high frequency characteristics and method for producing the same.

### BACKGROUND

Since the physical properties such as permittivity and permittivity tangent of a liquid crystal polymer film as an insulation material are stable in a high frequency region, and since the polymer film has a low water absorption rate, applications of the liquid crystal polymer film to a high frequency substrate and a high speed transmission circuit have been studied.

However, since adhesion and affinity between the liquid crystal polymer and a metal conductor layer are poor, physical adhesion is at present reinforced by way of an anchoring effect which is attained by increasing surface roughness of a copper foil generally used as the metal conductor layer or by changing a particle form in roughening processing.

Since the surface roughness is reduced along with an increase in frequency in the high frequency region, a ratio of involvement of the surface roughness is increased due to the roughening of an interface between the liquid crystal polymer and the metal conductor layer to cause an increase in transmission loss. Therefore, there has been a problem that the properties of the liquid crystal polymer film inherently having the excellent high frequency characteristics are not sufficiently exhibited.

One of conventional techniques describes surface modification which enables to achieve an oxygen atom/carbon atom molar ratio of a surface portion which is 1.2 times of that of an internal molar portion and is attained by performing gas discharge plasma processing on a thermoplastic liquid crystal polymer film in the presence of a gaseous oxygen atom-containing compound (Patent Literature 1). In this case, the modification which is caused by the oxygen introduction into the liquid crystal polymer film is the essential requirement. Also, since the literature refers only to the surface modification by oxygen, it describes the plasma processing in the presence of the oxygen-containing compound and does not describe a surface modification effect which is attained by others such as gas.

Patent Literature 2 describes that a thermoplastic liquid crystal polymer film is subjected to discharge plasma processing under an atmosphere of an oxygen gas pressure of 0.6 to 2.5 Pa. The literature defines roughness of the liquid crystal polymer film but does not describe any other influences than the influence that the increase in surface roughness inhibits formation of a uniform metal seed layer.

Patent Literature 3 discloses the method for attaining adhesion strength between an insulation film and a copper layer by dissolving 0.5 to 4.8 at% of nitrogen atoms into a tie-coat layer as a solid solution but does not describe the insulation film surface modification attained by employing plasma processing.

Patent Literature 1 and Patent Literature 2 are based on the findings that the surface modification effect of the liquid crystal polymer film is attained by the oxygen gas plasma processing and aim surface modification by plasma processing using other types of gas. Patent Literatures 1 and 2 do not describe anything about the contents of the invention of the present application described below, i.e. about the feature that the surface roughness is not changed before and after the processing and the feature that the excellent high frequency characteristics that the liquid crystal polymer film inherently has are maintained.

### Prior Art Document

Patent Literature 1: JP 2001-49002 A
Patent Literature 2: JP 2005-297405 A
Patent Literature 3: WO 2008/090654 A

### SUMMARY OF INVENTION

### Technical Problem

The present invention provides a liquid crystal polymer based copper-clad laminate having excellent high frequency characteristics by keeping roughness of an interface between the liquid crystal polymer and a metal conductor layer to original film roughness and strengthening chemical adhesion by plasma processing.

### Solution to Problem

The present invention provides:
1) A liquid crystal polymer film based copper-clad laminate wherein a surface of one side or each of both sides of a liquid crystal polymer film has a nitrogen atom content of 10 at% or more, the liquid crystal polymer film based copper-clad laminate comprises a metal conductor layer which is formed by dry plating and/or wet plating on the surface of the liquid crystal polymer film having the nitrogen atom content of 10 at% or more.
2) The liquid crystal polymer film based copper-clad laminate according to 1), wherein the surface of one side or each of both sides of the liquid crystal polymer film has a nitrogen atom content of 10 at% or more and a nitrogen atom/carbon atom ratio of 0.13 or more;
3) The liquid crystal polymer film based copper-clad laminate according to 1) or 2), wherein the surface of one side or each of both sides of the liquid crystal polymer film has a nitrogen atom content of 10 at% or more and a nitrogen atom/oxygen atom ratio of 0.7 or more;
4) The liquid crystal polymer film based copper-clad laminate according to any one of 1) to 3), wherein the liquid crystal polymer film has surface roughness which is represented by arithmetic average roughness Ra of 0.15 µm or less and root-mean-square roughness Rq of 0.20 µm or less;
5) The liquid crystal polymer film based copper-clad laminate according to any one of 1) to 4), wherein a barrier layer is formed between the liquid crystal polymer film surface and the metal conductor layer formed by dry plating and/or wet plating;
6) The liquid crystal polymer film based copper-clad laminate according to 5), wherein the barrier layer is a tie-coat layer comprising nickel or a nickel alloy, cobalt or a cobalt alloy, or chromium or a chromium alloy; and
7) The liquid crystal polymer film based copper-clad laminate according to any one of 1) to 6), wherein the metal conductor layer comprises a copper sputtered layer and an electrolytic copper plated layer formed on the copper sputtered layer.

Also, the present invention provides:
8) A method for producing a liquid crystal polymer film based copper-clad laminate comprising steps of: subjecting a surface of one side or each of both sides of a liquid crystal polymer film to plasma processing under a nitrogen atmosphere of a gas pressure of 2.6 to 15 Pa to attain a nitrogen atom content of 10 at% or more; and forming a metal conductor layer on the plasma-processed liquid crystal polymer film surface by dry plating and/or wet plating;
9) The method for producing a liquid crystal polymer film based copper-clad laminate according to 8), wherein a nitrogen atom/carbon atom ratio of the plasma-processed liquid crystal polymer film surface of 0.13 or more is attained;
10) The method for producing a liquid crystal polymer film based copper-clad laminate according to 8) or 9), wherein a nitrogen atom/oxygen atom ratio of the plasma-processed liquid crystal polymer film surface of 0.7 or more is attained;
11) The method for producing a liquid crystal polymer film based copper-clad laminate according to any one of 8) to 10), wherein surface roughness of the liquid crystal polymer film which is represented by arithmetic average roughness Ra of 0.15 µm or less and root-mean-square roughness Rq of 0.20 µm or less is attained by subjecting the liquid crystal polymer film to plasma processing;
12) The method for producing a liquid crystal polymer film based copper-clad laminate according to any one of 8) to 11), wherein a barrier layer is formed between the plasma-processed liquid crystal polymer film surface and the metal conductor layer formed by dry plating and/or wet plating;
13) The method for producing a liquid crystal polymer film based copper-clad laminate according to 12), wherein a tie-coat layer comprising nickel or a nickel alloy, cobalt or a cobalt alloy, or chromium or a chromium alloy is formed as a barrier layer; and
14) The method for producing a liquid crystal polymer film based copper-clad laminate according to any one of 8) to 13), wherein a copper sputtered layer is formed as a metal conductor layer in advance, and an electrolytic copper plated layer is formed on the sputtered layer.

### Effects of Invention

The present invention has the following excellent effects. By forming a metal conductor layer by dry plating and/or wet plating after subjecting a surface of a liquid crystal polymer film of the present invention to plasma processing under an oxygen atmosphere or nitrogen atmosphere of a gas pressure of 2.6 to 15 Pa, roughness of an interface between the liquid crystal polymer and the metal conductor layer is maintained to a value equal to original roughness of the film, and an adhesion property is chemically improved by the plasma processing, thereby providing a liquid crystal polymer film based copper-clad laminate having excellent high frequency characteristics.

### BRIEF DESCRIPTION OF DRAWINGS

Fig. 1 is a diagram schematically showing a copper-clad laminate which is one example of the invention of the present application, in which a tie-coat layer, a copper sputtered layer and an electrolytic copper plated layer are formed on each of both sides of a liquid crystal polymer film;
Fig. 2 is a diagram showing a relationship between power density of plasma processing and a surface composition (C, N, O, and F) of each of Examples;
Fig. 3 is a diagram showing a relationship between a nitrogen at% value and peeling strength of a film surface;
Fig. 4 is a diagram showing spectrums of C1s of Examples 1 and 2 and Comparative Examples 1 and 2;
Fig. 5 is a diagram showing spectrums of N1s of Examples 1 and 2 and
Comparative Example 1; and
Fig. 6 is a diagram showing spectrums of O1s of Examples 1 and 2 and Comparative Examples 1 and 2.

### DETAILED DESCRIPTION OF INVENTION

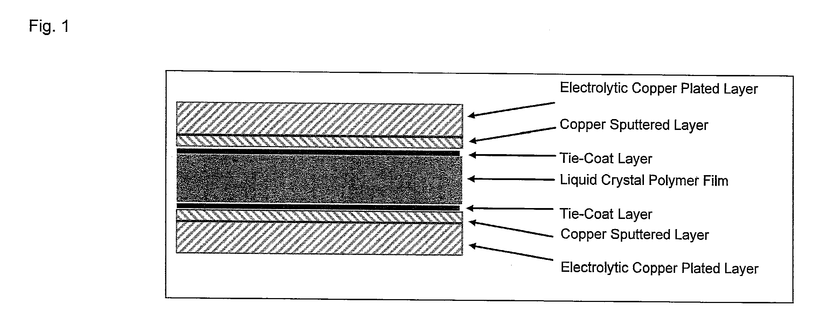

With a liquid crystal polymer film based copper-clad laminate according to the present invention, both of surfaces or one of the surfaces of a liquid crystal polymer film shown in Fig. 1 as one Example is subjected to plasma processing under a nitrogen atmosphere in order to impart a property of adhering to a metal conductor layer, and a barrier layer of a metal or an alloy having barrier effect is provided by sputtering, dry plating such as vapor deposition, or wet plating.

After that, a conductor layer of copper or a copper alloy is stacked on the barrier layer by sputtering or dry plating such as vapor deposition; or a conductor layer is formed by wet plating such as non-electrolytic copper plating and electrolytic copper plating, thereby forming a copper-clad laminate.

The liquid crystal polymer include a rheotropic liquid crystal polymer of which a typical example is aromatic polyamide and a thermotropic liquid crystal polymer of which a typical example is aromatic polyester.

For the copper-clad laminate, the thermotropic liquid crystal polymer which is less hygroscopic and has a small dimension change ratio caused by moisture absorption is preferred. The thermotropic liquid crystal polymer has less heat resistance as a thermoplastic resin than polyimide and aromatic polyamide but falls into the category of super engineering plastics which are excellent in heat resistance.

Extrusion molding is employed as a method for molding the thermotropic liquid crystal polymer into a film, and T-die extrusion, inflation extrusion and the like are industrially performed.

As the thermotropic liquid crystal polymer film to be used in the present invention, those made from p-hydroxybenzoic acid and polyethylene terephthalate, those made from p-hydroxybenzoic acid, terephthalic acid, and 4,4'-dihydroxybiphenyl, and those made from p-hydroxybenzoic acid and 2,6-hydroxynaphthoic acid are developed and commercially available.

Examples other than those described above include films such as Vecstar-CT-Z, CT-F, Fb, and OC manufactured by Kuraray Co., Ltd. and films such as BIAC BA and BC manufactured by Japan Gore-Tex Inc. which are commercially available. It is possible to use the above-described materials, but it is easily understandable that the above-described types are not limitative.

The plasma processing is performed on the liquid crystal polymer film in order to attain the adhesion to the metal conductor layer as described above. An anchoring effect which is attained by an increase in surface roughness through plasma processing is not expected from the plasma processing, but it is important to impart the adhesion property by performing the plasma processing to a degree that the surface roughness is scarcely changed, namely, by strengthening the chemical bonding between the polymer and the metal.

The increase in surface roughness causes a negative effect on a transmission loss in a high frequency region, and, therefore, it is desirable to reduce the surface roughness to achieve the high frequency characteristics which are ordinarily targeted in copper-clad laminates using liquid crystal polymer.

Also, the plasma processing using nitrogen gas of the invention of the present application enables to form a new bonding between the polymer and the metal by introducing nitrogen which originally is not present in the liquid crystal polymer film.

The plasma processing performed under the nitrogen gas atmosphere enables to strengthen the adhesion between the polymer and the metal. As to the plasma gas pressure, the plasma discharge becomes unstable when the gas pressure is low to make it difficult to perform the processing.

Whereas, when the gas pressure is high, the plasma discharge is stabilized, but, a leaked gas amount is increased to waste the gas. Too high a gas pressure is not favorable from economic point of view. Thus, the gas pressure may preferably be 2.6 to 15 Pa.

Thus, in the invention of the present application, the surface modification of the liquid crystal polymer film is attained by performing the plasma processing in the nitrogen gas. The modification enables to keep the nitrogen atomic percent on the surface of the liquid crystal polymer film to 10 at% or more, to keep the nitrogen atom/carbon atom ratio to 0.13 or more, and to keep a nitrogen atom/oxygen atom ratio to 0.7 or more, thereby realizing drastic improvement in adhesion between the liquid crystal polymer film surface with the metal. The process and the phenomenon do not exist in the prior art and, therefore, are novel.

A tie-coat layer shown in Fig. 1 is equivalent to the barrier layer, and a metal such as nickel, cobalt, and chromium or a nickel alloy, a cobalt alloy, or a chromium alloy, each of which exhibits the barrier effect, are suitably used for the tie-coat layer. The metals have a smaller conductivity compared to copper of the conductor layer, and a current flows on the surface by a skin effect in the high frequency region, so that the tie-coat layer becomes greatly contributory as a resistive layer.

From the viewpoint of high frequency characteristics, absence of the tie-coat is preferable. However, as the copper-clad laminate for printed wiring boards, copper is diffused into the polymer in the long run when there is no barrier layer such as the tie-coat layer, and adverse effect such as disconnection of the bonding can occur in some cases.

Thus, practically, it is desirable to use the metal or alloy having large conductivity for the tie-coat layer and to keep a thickness of the tie-coat layer as small as possible. Depending on use conditions of element, it is not necessary to form the tie-coat layer when it is considered as such.

Sputtering, vapor deposition, non-electrolytic plating, or the like is employable for the tie-coat layer, and, in view of the process flow from the plasma processing, it is industrially easy to perform the sputtering in a chamber where the plasma processing is performed.

After providing the tie-coat layer, a metal conductor layer to be primarily used for allowing a current to flow therethrough is formed, and it is possible to form a copper layer by sputtering in view of the process flow of the dry processing.

However, in the case where a target copper thickness is above 1 µm, sputtering is disadvantageous from cost point of view to form the metal conductor layer having the predetermined thickness. In such a case, it is preferable to form a copper seed layer of several hundreds of nanometers on the tie-coat layer and then to perform copper plating by wet plating to attain the predetermined copper thickness.

By performing the plasma processing on the liquid crystal polymer film, it is possible to attain the surface roughness of the liquid crystal polymer film which is represented by arithmetic average roughness Ra of 0.15 µm or less and root-mean-square roughness Rq of 0.20 µm or less.

In view of the degree of the surface roughness, it should be understood that the substantial object of the plasma processing is not the roughening of the surface of the liquid crystal polymer film. However, in order to attain the adhesion to the copper layer, it is necessary to keep the arithmetic average roughness Ra to 0.05 µm or more at least, preferably 0.1 µm or more, as the surface roughness of the liquid crystal polymer film.

By the processing described above, it is possible to maintain a transmission loss per length of the copper-clad laminate to 20 dB/m or less at 5 GHz, to 50 dB/m or less at 20 GHz, and further to 130 dB/m or less at 40 GHz.

### Examples

Examples will be described in conjunction with Comparative Examples, and the following description is for the purpose of facilitating the understanding and is not for the purpose of limiting the essence of the invention. In other words, the following description encompasses other modes or modifications encompassed by the invention.

### (Example 1)

As a liquid crystal polymer film, BIAC BC (50 µm) manufactured by Japan Gore-Tex Inc. was used. The liquid crystal polymer film was subjected to plasma processing under a nitrogen atmosphere at a gas pressure of 13 Pa and powder density of 4.3.

Intensity of the plasma is indicated by the power density, but, since plasma intensity which is generally defined by an applied voltage and a processing time may be meaningless in view of the fact that processing conditions such as a target size, current-voltage characteristics, a processing speed, etc. vary depending on devices, the plasma density is described as the power density when the condition for subjecting a polyimide film to the plasma processing is 1.

A surface shape of the liquid crystal polymer film after the plasma processing was measured by a surface shape measurement device "Wyco NT1100" manufactured by Veeco Instruments, Inc. to measure surface roughness in a visual field of 120 µm × 92 µm, thereby detecting arithmetic average roughness Ra and root-mean-square roughness.

On the plasma-processed liquid crystal polymer film, a Cr tie-coat layer of 3 nm and a copper sputtered layer of 200 nm which was a seed layer for wet plating were formed by sputtering. After that, a copper layer was grown to 18 µm on the copper sputtered layer by electrolytic plating to obtain a sample.

Peel strength of the sample was measured in order to evaluate an adhesion property. For the peel strength measurement, a pattern having a 3 mm width was formed by using a copper chloride etching liquid, and then the peel strength was measured by using "Bond Tester 4000" manufactured by Dage Japan Co., Ltd.

Results of the surface roughness and the peel strength are shown in Table 1. The surface roughness values are Ra = 0.10 µm and Rq = 0.14 µm, and the peel strength is 0.88 kN/m. Though the film surface roughness values are small, the peel strength which is favorable and not problematic in terms of practical use is achieved.

**[Table 1]**

| | Film | Plasma conditions | | | Film surface roughness | | Tie-coat layer | | Peel Strength |
|---|---|---|---|---|---|---|---|---|---|
| | | Gas pressure (Pa) | Gaseous species | Power density | Ra (mm) | Rq (mm) | Species | Thickness (nm) | (kN/m) |
| Example 1 | BIAC | 13 | Nitrogen | 4.3 | 0.1 | 0.14 | Cr | 3 | 0.88 |
| Example 2 | BIAC | 13 | Nitrogen | 2.6 | 0.11 | 0.15 | Cr | 3 | 0.57 |
| Example 3 | BIAC | 3 | Nitrogen | 4.3 | 0.11 | 0.14 | Cr | 3 | 0.90 |
| Example 4 | BIAC | 3 | Nitrogen | 4.3 | 0.11 | 0.15 | NiCr | 3 | 0.85 |
| Example 5 | Vecstar | 13 | Nitrogen | 4.3 | 0.1 | 0.15 | Cr | 3 | 0.80 |
| Com. Example 1 | BIAC | 13 | Nitrogen | 1.3 | 0.1 | 0.14 | Cr | 3 | 0.40 |
| Com. Example 2 | BIAC | 13 | Nitrogen | 0 | 0.11 | 0.15 | Cr | 3 | 0.00 |
| Com. Example 3 | BIAC | 13 | Nitrogen | 4.3 | 0.1 | 0.14 | Cr | 3 | 0.55 |
| Com. Example 4 | Kapton | 10 | Nitrogen | 1 | 0.04 | 0.06 | NiCr | 3 | 0.99 |
| Com. Example 5 | BIAC | Rolled copper foil | | | 0.18 | 0.23 | - | - | 0.30 |

### (Example 2)

The same conditions as in Example 1 were employed except for changing the power density of the plasma processing to 2.6. Results are shown in Table 1. As shown in Table 1, the surface roughness values are Ra = 0.11 µm and Rq = 0.15 µm to prove that the surface roughness values are not so much changed by the reduction in power density. However, the peel strength is 0.57 kN/m to indicate that the peel strength is reduced along with the reduction in power density. However, the peel strength is 0.5 kN/m which is not problematic in terms of practical use.

### (Example 3)

The same conditions as in Example 1 were employed except for changing the gas pressure of the plasma processing to 3 Pa. Results are shown in Table 1. As shown in Table 1, the surface roughness values are Ra = 0.11 µm and Rq = 0.14 µm, and the peel strength is 0.90 kN/m which is favorable and not problematic in terms of practical use.

### (Example 4)

The same conditions as in Example 3 were employed except for changing the tie-coat layer to NiCr. Results are shown in Table 1. As shown in Table 1, the surface roughness values are Ra = 0.11 µm and Rq = 0.14 µm, and the peel strength is 0.85 kN/m, which is not so much different from Example 3.

### (Example 5)

The same conditions as in Example 1 were employed except for changing the liquid crystal polymer film to CT-Z (50 µm) manufactured by Kuraray Co., Ltd. Results are shown in Table 1. As shown in Table 1, the surface roughness values are Ra = 0.10 µm and Rq = 0.15 µm, and the peel strength is 0.80 kN/m. It is proved that the favorable peel strength is achieved even when the film is changed.

### (Comparative Example 1)

The same conditions as in Example 1 were employed except for changing the power density of the plasma processing to 1.3. Results are shown in Table 1. As shown in Table 1, the surface roughness values are Ra = 0.10 µm and Rq = 0.14 µm. The surface roughness values are the same as Example 1, but the peel strength is lowered to 0.40 kNm, and it is difficult to determine whether or not this value is satisfactory in practical use for a printed wiring board. Thus, it is proved that the smaller power density results in the smaller peel strength.

### (Comparative Example 2)

The same conditions as in Example 1 were employed except for passing the film through the processing gas without applying power in the plasma processing. Results are shown in Table 1. As shown in Table 1, the surface roughness values are Ra = 0.11 µm and Rq = 0.15 µm which are the same as the original values of the film.

As to the peel strength, when growing a copper layer by electrolytic plating after forming a tie-coat layer and a copper sputtered layer on the liquid crystal polymer which was not subjected to the plasma treatment, it was impossible to perform the electrolytic plating since the adhesion between the liquid crystal polymer and the metal conductor layer was insufficient.

### (Comparative Example 3)

The same conditions as in Example 1 were employed except for changing the gas species of the plasma processing to oxygen. Results are shown in Table 1. As shown in Table 1, the surface roughness values are the same as Example 1, but the peel strength is 0.55 kN/m which is lower than that of the film sputtered with nitrogen. It is confirmed that the oxygen gas in the plasma processing has a smaller effect of improving the film/metal adhesion in the liquid crystal polymer film as compared to the nitrogen gas.

### (Comparative Example 4)

The same conditions as in Example 1 were employed except for using Kapton E (50 µm) manufactured by Du Pont-Toray Co., Ltd. as a polyimide film and performing the standard plasma processing for polyimide by using an oxygen gas at a power density of 1 and a gas pressure of 10 Pa. Results are shown in Table 1. As shown in Table 1, the surface roughness values are Ra = 0.04 µm and Rq = 0.06 µm, which indicate a surface of the untreated polyimide film having small roughness. The peel strength is 0.99 kN/m which is high. However, since the film is not the liquid crystal polymer film, it is not usable as a material for high frequency circuit substrates and high speed transmission circuits.

### (Comparative Example 5)

As an ordinary method to be employed in the case of using a liquid crystal polymer for a copper-clad laminate, heat lamination was performed. Comparative Example 5 shows results of using a rolled copper foil (BHY (18 µm) manufactured by JX Nippon Mining & Metals Corporation) as a copper-clad laminate prepared by the heat lamination. The results are shown in Table 1.

By the heat lamination of the rolled copper foil, surface roughness of the film reflects a surface shape of the rolled copper foil, and, therefore, the surface roughness values are large as shown in Table 1.

As to the peel strength, it was difficult to achieve strong adhesion since the plasma processing was not performed on the liquid crystal polymer film in the heat lamination method for attaching the copper foil itself to the film as in Comparative Example 5, though roughening processing of the copper foil which causes an anchoring effect of allowing the copper foil to be buried in the softened film is the main factor for achieving an adhesion power. The peel strength was 0.3 kN/m, and did not achieve the satisfactory adhesion.

XPS analysis was performed on Example 1 and Example 2 and Comparative Example 1 and Comparative Example 2 as a means for evaluating a degree of modification of a surface in the case where the power density of the plasma processing under the nitrogen atmosphere was changed. The results are shown in Table 2. As a measurement device for the XPS measurement, 5600MC manufactured by Ulvac-Phi, Inc. was used. The measurement conditions are as described below.
Ultimate vacuum: 2.0 × 10⁻⁹ Torr
Excitation source: Monochromatic Alkα
Output: 210 W
Detection area: 800 µm²
Incident angle: 45 degrees
Takeoff angle: 45 degrees using neutralization gun
Sputtering conditions: ion species of Ar⁺, acceleration voltage of 3kV, sweep area of 3 mm × 3 mm

**[Table 2]**

| | Power density | C | N | O | F | Normal state peeling | N/C | N/O |
|---|---|---|---|---|---|---|---|---|
| | | (at%) | (at%) | (at%) | (at%) | (kN/m) | | |
| Example 1 | 4.3 | 72.1 | 16.4 | 10.9 | 0.6 | 0.88 | 0.23 | 1.50 |
| Example 2 | 2.6 | 73.7 | 11.7 | 14.2 | 0.3 | 0.57 | 0.16 | 0.82 |
| Com. Example 1 | 1.3 | 79.8 | 6.5 | 13.4 | 0.4 | 0.40 | 0.08 | 0.49 |
| Com. Example 2 | 0 | 80.1 | 0 | 19.6 | 0.3 | 0 | 0.00 | 0.00 |

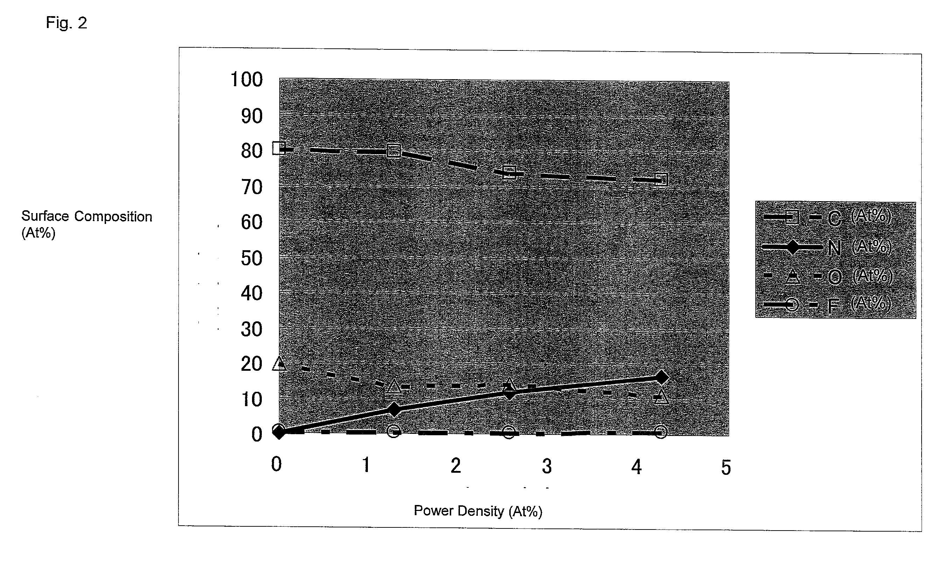

Shown in Fig. 2 is a relationship between each of surface compositions shown in Table 2, i.e. atomic percent of carbon, nitrogen, oxygen, and fluorine and the power density of the plasma processing. The nitrogen atomic percent was initially zero when the power density was zero, and it is confirmed that the nitrogen atomic percent is increased along with the increase in power density.

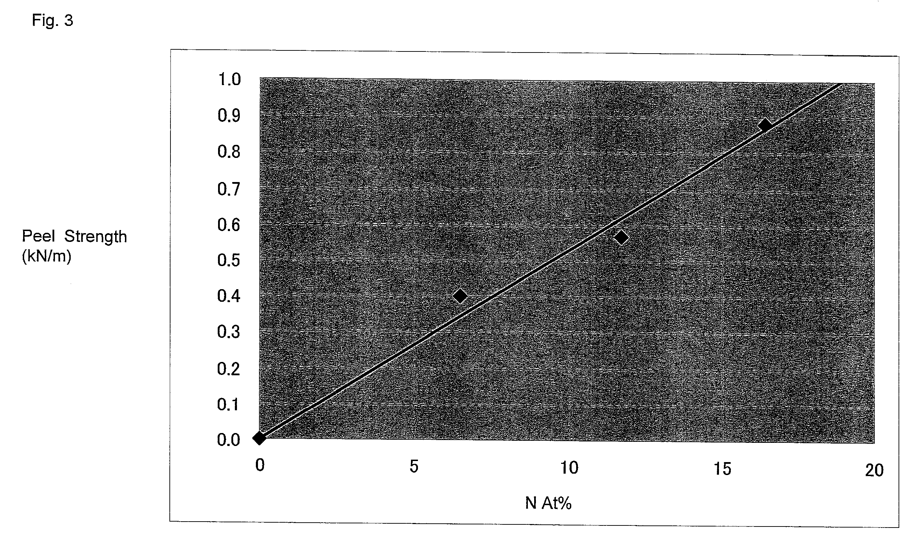

Shown in Fig. 3 is a relationship between the nitrogen atomic percent and the peel strength shown in Table 2, and it is confirmed that the peel strength is increased along with the progress of the surface modification and the increase in nitrogen atomic percent.

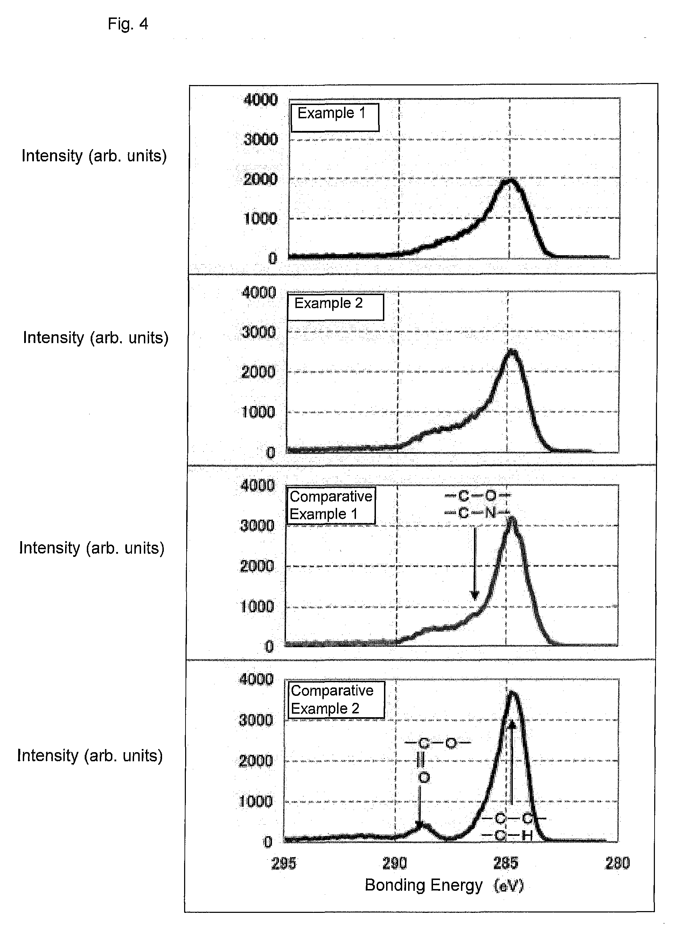

Results of bonding energy and strength detected by XPS of carbon, nitrogen, and oxygen are shown in Figs. 4 to 6. Fig. 4 is the example of carbon, and two peaks each near 285 eV and 288 eV are confirmed in Comparative Example 2 in which the power density was zero. The peak near 285 eV attributes to -C-C- or -C-H; and the peak intensity is reduced along with the increase in power density in the order of Comparative Example 1, Example 2, and Example 1.

In contrast, the peak near 285 eV becomes broader along with the increase in power density, and the increase in intensity attributable to -C-O- or -C-N- near 287 eV is the cause for the broadening.

The peak near 288 eV attributes to -C(=O)- in which a large change relative to the power density is not confirmed as compared to the peak reduction near 285 eV.

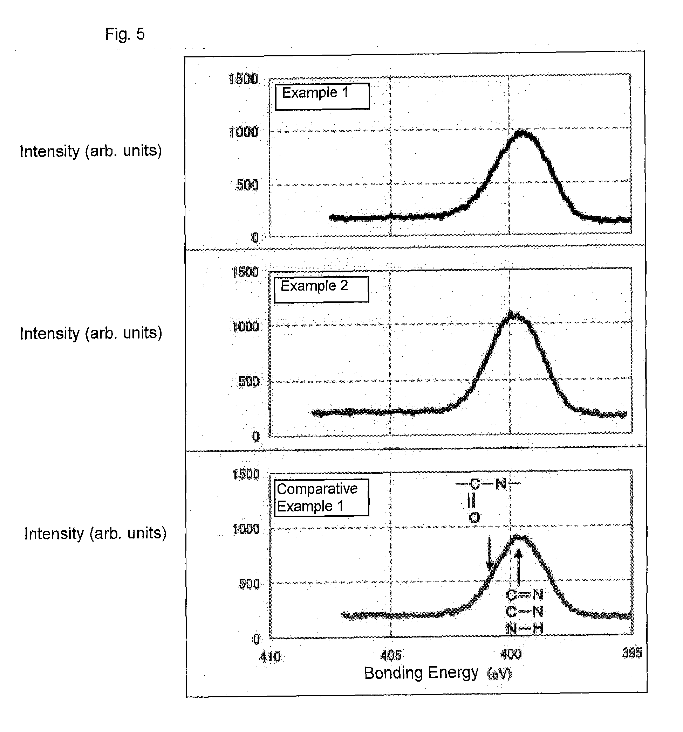

Shown in Fig. 5 is the example of nitrogen, and nitrogen is not detected in Comparative Example 2 in which the power density was zero. There is no clear difference among the peaks near 400 eV of Comparative Example 1, Example 2 and Example 1.

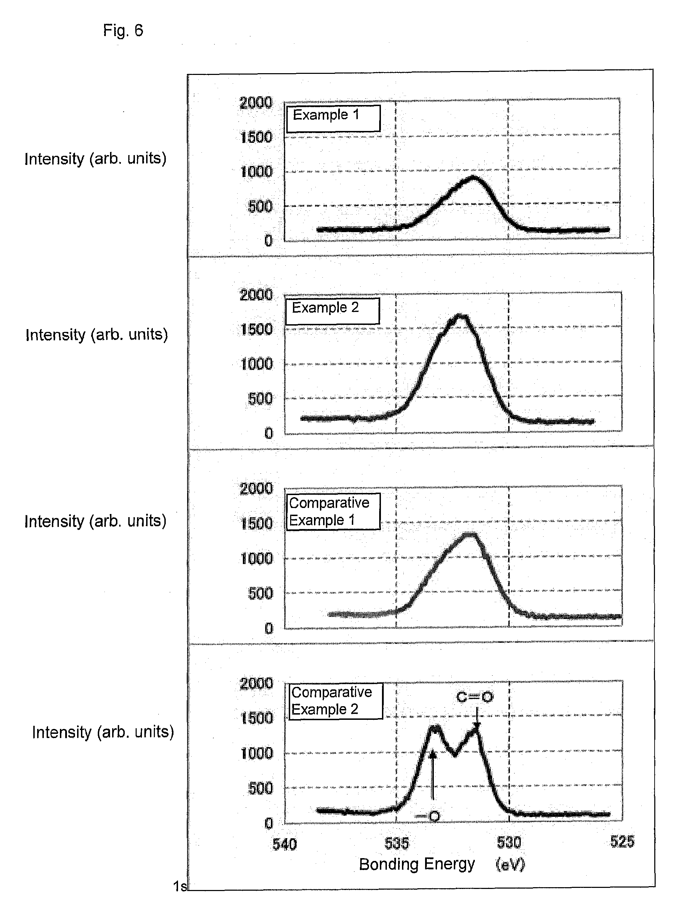

Shown in Fig. 6 is the examples of oxygen, and the peaks are confirmed near 532 eV and 533 eV in Comparative Example 2 in which the power density was zero. Along with the increase in power density, the peak near 533 eV disappears, and it seems that the peak changes between 532 and 533 eV. The peak position attributes to bonding between O and N as in a nitric acid salt.

As a result of subjecting the liquid crystal polymer film to the plasma processing with the nitrogen gas, the nitrogen-containing functional group which does not originally exist is introduced. Thus, as confirmed by the XPS analysis, the C-H bonding is substituted with C-N, and the ether bonding -O- is changed to -C(=O)-N-. Hence, the bonding between nitrogen and the tie-coat metal which is not attained by the oxygen gas plasma processing is formed in addition to the bonding between oxygen and the tie-coat metal. The effect of increasing the peel strength is thereby achieved.

In the present invention, as a result of subjecting the surface of the liquid crystal polymer film to the plasma processing at the gas pressure of 2.6 to 15 Pa under the nitrogen atmosphere, the liquid crystal polymer film surface is modified so as to attain the nitrogen atomic percent of 10 at% or more, the nitrogen atom/carbon atom ratio of 0.13 or more, and the nitrogen atom/oxygen atom ratio of 0.7 or more though the surface roughness, which is represented by the arithmetic average roughness Ra of 0.15 µm or less and the root-mean-square roughness Rq of 0.20 µm or less, is not changed from the original surface roughness of the film.

The copper-clad laminate obtained by forming the metal conductor layer by dry plating, wet plating, or dry plating and wet plating after the plasma processing attains the favorable adhesion between the polymer and the tie-coat metal layer, thereby enabling to provide a printed wiring material having favorable peel strength.

### Industrial Applicability

A copper-clad laminate which is obtained by subjecting a surface of the liquid crystal polymer film of the present invention to the plasma processing under an oxygen atmosphere or nitrogen atmosphere at a gas pressure of 2.6 to 15 Pa to attain surface modification of achieving a nitrogen atom content of 10 at% or more on the plasma-processed surface and then forming a metal conductor layer by dry plating and/or wet plating on the plasma-processed liquid crystal polymer film has the excellent effect of enabling to provide a liquid crystal polymer based copper-clad laminate having excellent high frequency characteristics since roughness of an interface between the liquid crystal polymer and the metal conductor layer is maintained to the original film roughness and since the chemical adhesion is strengthened by the plasma processing. Therefore, it is possible to use the liquid crystal polymer-based copper-clad laminate for high frequency circuit substrates and high speed transmission circuits.

## Claims

1. A liquid crystal polymer film based copper-clad laminate wherein a surface of one side or each of both sides of a liquid crystal polymer film has a nitrogen atom content of 10 at% or more, the liquid crystal polymer film based copper-copper-clad laminate comprises a metal conductor layer which is formed on the surface of the liquid crystal polymer film having the nitrogen atom content of 10 at% or more by dry plating and/or wet plating.

2. The liquid crystal polymer film based copper-clad laminate according to claim 1, wherein the surface of one side or each of both sides of the liquid crystal polymer film has a nitrogen atom content of 10 at% or more and a nitrogen atom/carbon atom ratio of 0.13 or more.

3. The liquid crystal polymer film based copper-clad laminate according to claim 1 or 2, wherein the surface of one side or each of both sides of the liquid crystal polymer film has a nitrogen atom content of 10 at% or more and a nitrogen atom/oxygen atom ratio of 0.7 or more.

4. The liquid crystal polymer film based copper-clad laminate according to any one of claims 1 to 3, wherein the liquid crystal polymer film has surface roughness which is represented by arithmetic average roughness Ra of 0.15 µm or less and root-mean-square roughness Rq of 0.20 µm or less.

5. The liquid crystal polymer film based copper-clad laminate according to any one of claims 1 to 4, wherein a barrier layer is formed between the liquid crystal polymer film surface and the metal conductor layer formed by dry plating and/or wet plating.

6. The liquid crystal polymer film based copper-clad laminate according to claim 5, wherein the barrier layer is a tie-coat layer comprising nickel or a nickel alloy, cobalt or a cobalt alloy, or chromium or a chromium alloy.

7. The liquid crystal polymer film based copper-clad laminate according to any one of claims 1 to 6, wherein the metal conductor layer comprises a copper sputtered layer and an electrolytic copper plated layer formed on the copper sputtered layer.

8. A method for producing a liquid crystal polymer film based copper-clad laminate comprising steps of: subjecting a surface of one side or each of both sides of a liquid crystal polymer film to plasma processing under a nitrogen atmosphere of a gas pressure of 2.6 to 15 Pa to attain a nitrogen atom content of 10 at% or more; and forming a metal conductor layer on the plasma-processed liquid crystal polymer film surface by dry plating and/or wet plating.

9. The method for producing a liquid crystal polymer film based copper-clad laminate according to claim 8, wherein a nitrogen atom/carbon atom ratio of the plasma-processed liquid crystal polymer film surface of 0.13 or more is attained.

10. The method for producing a liquid crystal polymer film based copper-clad laminate according to claim 8 or 9, wherein a nitrogen atom/oxygen atom ratio of the plasma-processed liquid crystal polymer film surface of 0.7 or more is attained.

11. The method for producing a liquid crystal polymer film based copper-clad laminate according to any one of claims 8 to 10, wherein surface roughness of the liquid crystal polymer film which is represented by arithmetic average roughness Ra of 0.15 µm or less and root-mean-square roughness Rq of 0.20 µm or less is attained by subjecting the liquid crystal polymer film to plasma processing.

12. The method for producing a liquid crystal polymer film based copper-clad laminate according to any one of claims 8 to 11, wherein a barrier layer is formed between the plasma-processed liquid crystal polymer film surface and the metal conductor layer formed by dry plating and/or wet plating.

13. The liquid crystal polymer film based copper-clad laminate according to claim 12, wherein a tie-coat layer comprising nickel or a nickel alloy, cobalt or a cobalt alloy, or chromium or a chromium alloy is formed as a barrier layer.

14. The method for producing a liquid crystal polymer film based copper-clad laminate according to any one of claims 8 to 13, wherein a copper sputtered layer is formed as a metal conductor layer in advance, and an electrolytic copper plated layer is formed on the sputtered layer.
